# EUROPÄISCHE PATENTSCHRIFT

(11) **EP 1 116 327 B1**
(45) Veröffentlichungstag und Bekanntmachung des Hinweises auf die Patenterteilung: **01.10.2003**
(21) Anmeldenummer: 99945879.7
(22) Anmeldetag: 01.07.1999
(51) Int. Cl.: H03K 17/16

(54) **EINGANGSSCHALTUNG FÜR EINE ENDSTUFE**
INPUT CIRCUIT FOR AN OUTPUT STAGE
CIRCUIT D'ENTREE POUR UN ETAGE DE SORTIE

(30) Priorität: 23.09.1998 DE 19843562; 21.10.1998 DE 19848494
(43) Veröffentlichungstag der Anmeldung: 18.07.2001
(73) Patentinhaber: ROBERT BOSCH GMBH, 70442 Stuttgart (DE)
(72) Erfinder: SCHMIED, Helmut, D-71672 Marbach (DE); BIRECKOVEN, Bernd, D-77815 Buehl (DE); BERKEMER, Hans, D-75417 Grossglattbach (DE); MICHEL, Hartmut, D-72762 Reutlingen (DE)
(86) Internationale Anmeldenummer: DE9902023
(87) Internationale Veröffentlichungsnummer: WO00018011

(56) Entgegenhaltungen:
- WO-A-93/14569
- US-A- 4 398 098
- US-A- 5 617 048
- "POWER-ON CIRCUIT" IBM TECHNICAL DISCLOSURE BULLETIN., Bd. 29, Nr. 5, Oktober 1986 (1986-10), Seiten 2167-2168, XP002126407 IBM CORP. NEW YORK., US ISSN: 0018-8689

## Beschreibung

Die Erfindung betrifft eine Eingangsschaltung für eine Endstufe, die zwischen einer Signalleitung und einer durch das Signal gesteuerten Endstufe eingefügt wird, um Störimpulse zu unterdrücken, die z. B. durch elektromagnetische Induktionserscheinungen in der Signalleitung erzeugt werden können.

### Stand der Technik

In dem Artikel "Power-On Circuit", IBM Technical Disclosure Bulletin, Bd. 29, Nr. 5, Oktober 1986, Seiten 2167-2168 wird eine Schaltung beschrieben, die Stromspitzen während des Einschaltens eines Nutzschaltkreises (DRAM) vermeidet. In der US-A-5 617 048 wird eine Schaltung beschrieben, die dazu dient, einen Einschaltschutz eines Nutzschaltkreises zu gewährleisten.

Bei der Ansteuerung von Endstufen über eine elektrische Leitung von nicht vernachlässigbarer Länge tritt immer das Problem auf, zwischen "gewollter Ansteuerung" und Störeinflüssen, z. B. in Form von elektromagnetischen Induktionserscheinungen an der Leitung, zu unterscheiden. Im ersten Fall soll die Endstufe einen Strom von der Leitung aufnehmen, im zweiten Fall soll sie vorzugsweise das fehlerhaft anliegende Störsignal ignorieren. Dieses Problemfeld ist unter dem Begriff "elektromagnetische Verträglichkeit" (EMV) bekannt. Die gewünschte elektromagnetische Verträglichkeit läßt sich prinzipiell durch Auswertung der unterschiedlichen an der Endstufe anliegenden Spannungsniveaus erreichen: Beabsichtigte Steuersignale haben in der Regel einen festgelegten Spannungshub, der oberhalb eines für eine gegebene Anwendung charakteristischen Grenzwerts liegt. Auch auf elektromagnetische Störungen zurückgehende Signale hingegen haben einen geringeren Spannungshub, der von einem Störereignis zum anderen unterschiedlich sein kann und in der Regel kleiner ist als der der gewollten Steuersignale. So erfolgt z. B. bei einer Zündendstufe eines Kraftfahrzeugs die "gewollte" Ansteuerung mit Spannungen von mehr als 3 Volt, wohingegen durch elektrische oder elektromagnetische Störungen bedingte Signale auf der Steuerleitung einer solchen Zündendstufe typischerweise Werte von bis zu 2 Volt aufweisen. Zwar wird bei diesen unter dem Sollwert von 3 Volt liegenden Spannungen der Zünder nicht global aufgesteuert, die Störsignalpegel können jedoch insbesondere bei hoher Temperatur ausreichen, um Lastströme von mehr als 0,1A fließen zu lassen, so daß eine Auswirkung der Störung im Lastkreis nachweisbar ist.

Zur Unterdrückung der Störsignale sind diverse diskrete Eingangsbeschaltungen einer solchen Endstufe bekannt, die jedoch durch ihren diskreten Aufbau aufwendig in der Herstellung sind und unerwünscht viel Platz benötigen.

Es sind auch auf einem einzelnen Halbleitersubstrat integrierte Komparatoren bekannt, die immer dann ein diskretes Ausgangssignal erzeugen, wenn der Pegel eines anliegenden Eingangssignals einen Referenzwert überschreitet. Solche Komparatoren können einer Endstufe vorgeschaltet werden, um alle eintreffenden Impulse zu unterdrücken, die den Referenzwert (im oben erwähnten Fall einer Zündendstufe eine Referenzspannung von z. B. 3V) nicht überschreiten. Diese Komparatoren benötigen jedoch eine Versorgungsspannung sowie eine von außen zugeführte Referenzspannung, um ihre Aufgabe erfüllen zu können. Diese Referenzspannung aus einer Entfernung zuzuführen, ist nicht zweckmäßig, da dann die Zuleitung für die Referenzspannung in der gleichen Weise Störungen ausgesetzt ist wie die Steuerleitung. Wenn hingegen die Referenzspannung direkt in der Ansteuerschaltung erzeugt wird, so erhöht dies wieder den Aufwand, der zu ihrer Fertigung getrieben werden muß, die Kosten und den Platzbedarf.

### Vorteile der Erfindung

Die Ansteuerschaltung für eine Endstufe mit den im Anspruch 1 genannten Merkmalen bietet demgegenüber den Vorteil, daß sie eine zuverlässige Unterdrükkung von Störsignalen ermöglicht, ohne daß hierfür eine Referenzspannung zur Verfügung gestellt werden muß, daß sie ohne Versorgungsspannung arbeitet und daß sie zum Funktionieren lediglich Komponenten benötigt, die sich leicht auf einem Halbleitersubstrat integrieren lassen.

Solange am Signaleingang der Ansteuerschaltung kein Signal anliegt, befinden sich beide Schalterstufen in ihrem ersten Zustand. Wenn beim Eintreffen eines Signals das Potential am Signaleingang zunimmt, folgen die Potentiale beider Ausgabeanschlüsse nach, so daß zunächst auch ein ansteigendes Potential vom Signalausgang ausgegeben wird. Mit zunehmendem Potential am Signaleingang wird zuerst der Schwellwert der zweiten Schalterstufe überschritten, diese geht in ihren zweiten Zustand über, in dem ihr Ausgabeanschluß auf Masse gezogen ist. Da dieser auch der Signalausgang ist, wird kein Signal mehr ausgegeben; der am Signaleingang eintreffende Impuls wird unterdrückt. Steigt das am Signaleingang anliegende Potential weiter an, so wird auch der Schwellwert der ersten Schalterstufe überschritten, ihr Ausgang wird auf Masse gezogen, woraufhin die zweite Schalterstufe in ihren ersten Zustand zurückkehrt, in dem das Potential am Ausgabeanschluß dem am Signaleingang folgt. So wird ein Eingangssignal, das den Schwellwert der ersten Schalterstufe übersteigt, am Signalausgang ausgegeben, kleinere Signale werden unterdrückt.

Jede Schalterstufe kann in einfacher Weise durch einen Widerstand und einen Transistor gebildet werden, wobei der Widerstand zwischen den Kollektor des Transistors und den Signaleingang geschaltet ist und der Emitter des Transistors mit der Masse verbunden ist.

Die Basis dieses ersten beziehungsweise zweiten Transistors kann direkt den Steueranschluß der ersten beziehungsweise zweiten Schalterstufe bilden, im Fall der ersten Schalterstufe ist allerdings bevorzugtermaßen ein dritter Transistor vorgesehen, dessen Basis den Steueranschluß der Schalterstufe bildet und dessen Emitter die Basis des ersten Transistors steuert. Hierdurch wird ein steilerer Anstieg des Potentials an der Basis des ersten Transistors und damit eine schärfere Trennung zwischen oberhalb und unterhalb des Schwellwerts der ersten Schalterstufe liegenden Eingangssignalen erreicht.

Vorzugsweise ist noch ein vierter Transistor als Teil der zweiten Schalterstufe vorgesehen, dessen Kollektor mit dem Signaleingang verbunden ist, dessen Emitter den Ausgabeanschluß der zweiten Schalterstufe bildet und dessen Basis vom Kollektor des zweiten Transistors gesteuert wird. Dieser Transistor ist im ersten Zustand der zweiten Schalterstufe zwischen Emitter und Kollektor durchlässig und sperrt im zweiten Zustand die Verbindung zwischen Signaleingang und Signalausgang der Ansteuerschaltung.

Der Emitter des vierten Transistors kann über einen Widerstand mit Masse verbunden sein.

Die zweite Schwellspannung der Ansteuerschaltung ist diejenige Spannung, oberhalb derer kleine Störsignale wirksam unterdrückt werden. Diese sollte zweckmäßigerweise möglichst niedrig sein, vorzugsweise im Bereich der Halbleitergrenzschichtübergangsspannung. Die erste Schwellspannung kann je nach beabsichtigter Anwendung der Ansteuerschaltung weitgehend frei gewählt werden, bei einer Verwendung in Verbindung mit einer Zündendstufe eines Kraftfahrzeugs liegt die erste Schwellspannung zweckmäßigerweise oberhalb von 2 Volt.

### Zeichnungen

Ausführungsbeispiele der Erfindung sind in den Zeichnungen dargestellt und nachfolgend näher erläutert. Es zeigen:
Figur 1 eine Schaltskizze einer ersten Ausgestaltung einer erfindungsgemäßen Ansteuerschaltung;
Figur 2 eine Schaltskizze einer weiterentwickelten Ausgestaltung;
Figur 3 eine Strom-Spannungskennlinie der Ausgestaltung aus Figur 2; und
Figur 4 eine Schaltskizze einer abermals weiterentwickelten Ausgestaltung.

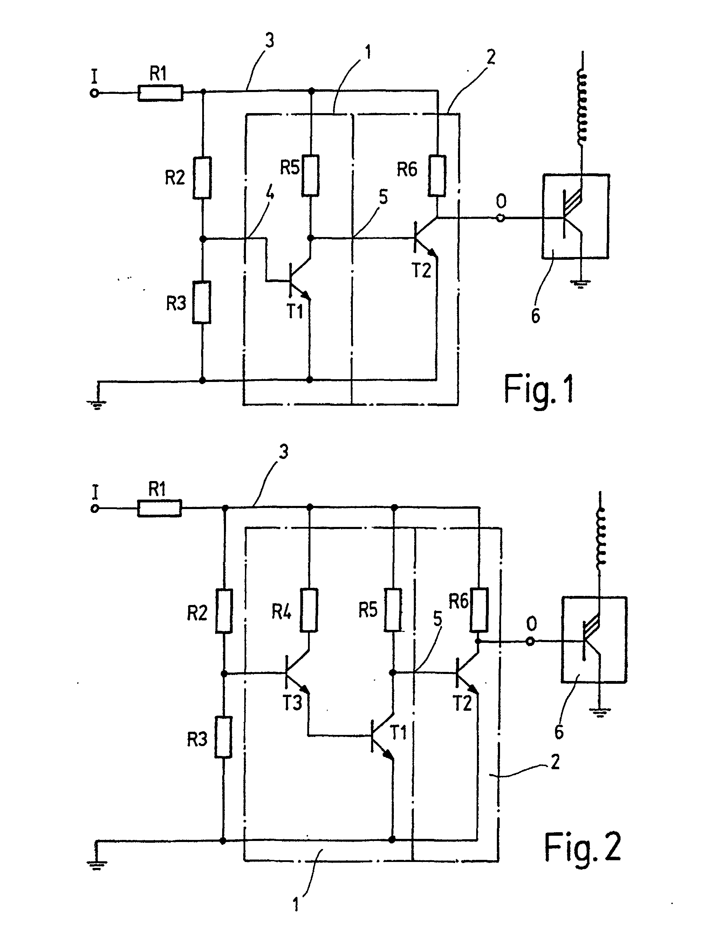

Die in Figur 1 dargestellte Ansteuerschaltung hat drei Anschlüsse, einen Signaleingang I, einen Signalausgang O und einen Masseanschluß. Der Signaleingang ist über einen Vorwiderstand R1 mit einer Eingangssignalleitung 3 verbunden, an die ein Spannungsteiler aus Widerständen R2, R3, eine erste Schalterstufe 1 un eine zweite Schalterstufe 2 angeschlossen sind. Die erste Schalterstufe enthält einen Transistor T1, dessen Kollektor über einen Widerstand R5 an die Eingangssignalleitung 3 angeschlossen ist, dessen Basis einen Steueranschluß 4 der Schalterstufe 1 bildet, der mit dem Mittenpunkt des Spannungsteilers R2, R3, verbunden ist und dessen Emitter an Masse angeschlossen ist. Ein Ausgabeanschluß 5 der ersten Schalterstufe ist direkt an den Kollektor des Transistors T1 angeschlossen.

Der Ausgabeanschluß 5 ist gleichzeitig Eingangsanschluß der zweiten Schalterstufe 2 und ist direkt mit der Basis eines zweiten Transistors T2 verbunden. Dessen Emitter ist ebenfalls an Masse angeschlossen, sein Kollektor ist über einen Widerstand R6 an die Eingangssignalleitung 3 sowie direkt an den Signalausgang O angeschlossen.

Wenn infolge des Eintreffens eines Signals am Eingang I das Potential auf der Eingangssignalleitung 3 zu steigen beginnt, fließt über den Widerstand R6 zunächst ein Strom in den Signalausgang O. Solange das Potential am Anschluß 5 kleiner ist als die Halbleitergrenzschicht-Übergangsspannung, ist der Transistor T2 undurchlässig, und der vom Signalausgang O ausgegebene Strom wächst mit dem Eingangssignal an. Da der Anschluß 5 über den Widerstand R5 mit der Eingangssignalleitung 3 verbunden ist, steigt jedoch an diesem Anschluß das Potential ebenfalls, und sobald es die Grenzschichtspannung überschritten hat, wird der Transistor T2 durchlässig, und der Strom am Signalausgang O fällt auf einen geringen Wert ab, der vom Kollektor-Emitter-Widerstand des Transistors T2 und dem Innenwiderstand der dem Signalausgang O nachgeschalteten Endstufe abhängt.

Wenn das Potential auf der Eingangssignalleitung weiter ansteigt, erreicht auch das Potential am Steueranschluß 4 einen Wert, bei dem der Transistor T1 durchlässig wird. Daraufhin fällt das Potential am Anschluß 5 wieder ab, der Transistor 1 sperrt, so daß der gesamte durch den Widerstand R6 fließende Strom über den Signalausang O die Endstufe erreicht.

Figur 2 zeigt eine weiterentwickelte Ausgestaltung der erfindungsgemäßen Ansteuerschaltung, die sich von der mit Bezug auf Figur 1 beschriebenen im Aufbau der ersten Schalterstufe 1 unterscheidet. Die erste Schalterstufe 1 enthält einen dritten Transistor T3, dessen Basis an den Mittenpunkt des Spannungsteilers R2, R3, angeschlossen ist, dessen Kollektor über einen Widerstand R4 an die Eingangssignalleitung 3 angeschlossen ist und dessen Emitter direkt mit der Basis des Transistors T1 verbunden ist.

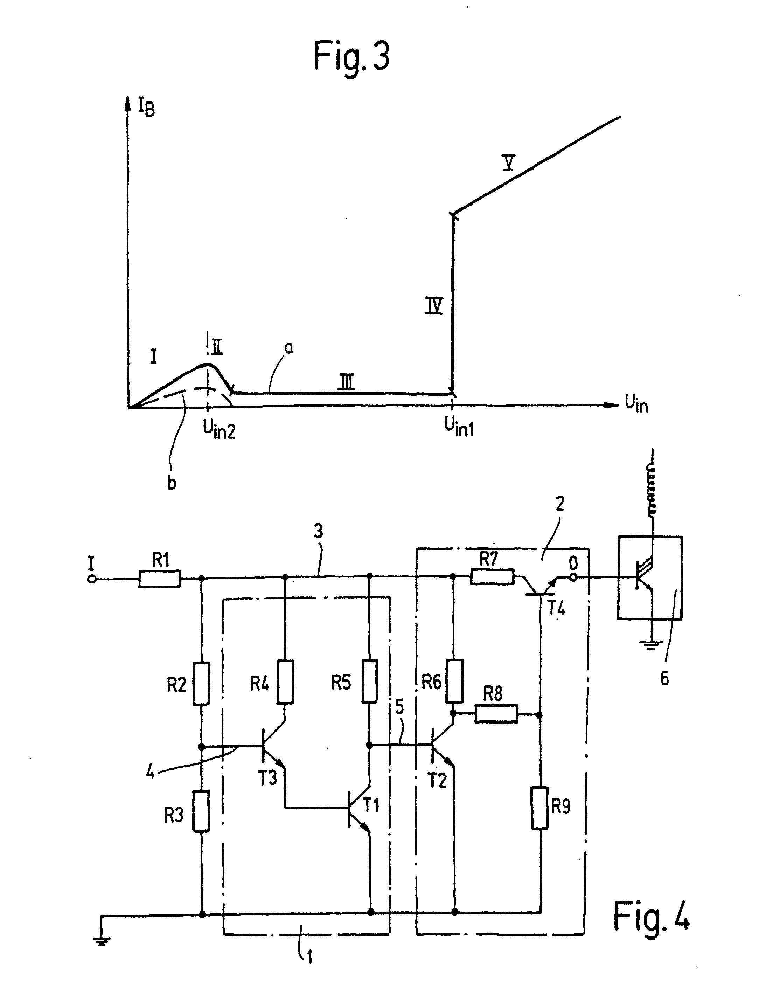

Das Verhalten dieser Ansteuerschaltung ist in Figur 2 dargestellt. Figur 3 zeigt ein Strom-Spannungsdiagramm, auf dessen Abszisse die Eingangsspannung Uᵢₙ am Signaleingang I aufgetragen ist und dessen Ordinate den Ausgangsstrom I_{B} am Signalausgang O angibt. Die gezeigte mit dem Symbol "a" bezeichnete Kennlinie der Schaltung aus Figur 2 hat fünf Phasen, die mit I bis V bezeichnet sind. In der ersten Phase, die sehr geringen Eingangssignalen entspricht, sind Eingangsspannung Uᵢₙ und Ausgangsstrom I_{B} linear proportional. In der zweiten Phase II nimmt der Ausgangsstrom mit zunehmender Eingangsspannung ab. Diese Phase entspricht dem Übergang der zweiten Schalterstufe 2 von ihrem ersten in den zweiten Zustand. In der Phase III befindet sich die zweite Schalterstufe in ihrem zweiten Zustand, in dem der Transistor T2 durchlässig ist, so daß das Eingangssignal im wesentlichen über diesen Transistor gegen Masse abfließt und nicht mehr zum Signalausgang O gelangt. Der Ausgangsstrom I_{B} ist daher klein.

Die Phase IV entspricht dem Übergang der ersten Schalterstufe vom ersten in den zweiten Zustand. Diese Phase erstreckt sich über ein Spannungsintervall von im Vergleich zur Phase II vernachlässigbarer Breite. Dies wird erreicht durch die Verwendung des Transistors T3. Dieser sorgt dafür, daß das an der Basis des Transistors T1 anliegende Potential nicht mehr linear mit dem Eingangspotential Uᵢₙ zunimmt, wie dies bei der Ausgestaltung nach Figur 1 der Fall ist, sondern er hält dieses Basispotential bei geringen Eingangsspannungen konstant auf einem niedrigen Wert, bei dem der Transistor T1 undurchlässig ist, und erzeugt, sobald er bei höheren Eingangsspannungen selber durchlässig wird, einen schnellen Anstieg des Basispotentials des Transistors T1, was ein abruptes Umschalten des Transistors T1 vom undurchlässigen in den durchlässigen Zustand ermöglicht.

Das Umschalten des Transistors T1 führt zu einem Rückgang des Potentials am Anschluß 5 auf einen niedrigen Wert, der dazu führt, daß der Transistor T2 der zweiten Schalterstufe 2 genauso wie in der Phase I undurchlässig wird. Folglich ist in der Phase V der Ausgangsstrom I_{B} wieder linear proportional zur Eingangsspannung Uᵢₙ, wie in Phase I.

Figur 4 zeigt eine abermals weiterentwickelte Ausgestaltung der Ansteuerschaltung. Sie unterscheidet sich von der in Figur 2 gezeigten dadurch, daß die zweite Schalterstufe 2 zusätzlich einen Transistor D4 enthält, dessen Kollektor über einen Widerstand R7 an die Eingangssignalleitung 3 angeschlossen ist, dessen Basis über einen Widerstand R8 an den Kollektor des Transistor T2 angeschlossen ist und dessen Emitter den Signalausgang O der Ansteuerschaltung bildet. Diese Ausgestaltung hat die in Figur 3 mit "b" bezeichnete Kennlinie.

Der Transistor T4 ist zwischen Kollektor und Emitter undurchlässig, solange die Eingangsspannung Uᵢₙ nicht die Halbleitergrenzschicht-Übergangsspannung übersteigt. Dieser Zustand entspricht der Phase I der Kurve b aus Figur 3. Mit zunehmender Eingangsspannung steigt über die Widerstände R6 und R8 auch das Potential an der Basis des Transistors T4, so daß dieser wenigstens teilweise durchlässig werden kann. Er bewirkt aber in jedem Fall eine Unterdrükkung des Ausgangsstroms in den Phasen I und II der Kurve b im Vergleich zum mit Bezug auf Figur 2 beschriebenen Ausführungsbeispiel.

In der Phase III ist der Transistor T2 wie bei den zuvor beschriebenen Ausgestaltungen durchlässig. Infolgedessen ist das Basispotential des Transistors T4 niedrig, dieser sperrt, und I_{B} ist praktisch Null. In der Phase V hingegen ist das Potential an der Basis des Transistors T4 groß genug, um diesen vollständig durchlässig zu machen, so daß sich das Verhalten der in Figur 4 gezeigten Schaltung in dieser Phase nicht wesentlich von der Schaltung aus Figur 2 unterscheidet. Die Kurven a und b der Figur 3 sind deshalb in Phasen IV und V nahezu deckungsgleich.

Die vorstehend beschriebenen Schaltungen bestehen ausschließlich aus Widerständen und Kondensatoren, welche sich ohne Schwierigkeiten auf einem gemeinsamen Halbleiter-Substrat integrieren lassen.

Das Verhalten der Transistoren beziehungsweise die Schwellspannungen Uᵢₙ₁, Uᵢₙ₂ der ersten und der zweiten Schalterstufe können eine Temperaturabhängigkeit aufweisen. Bei der Schwellspannung Uᵢₙ₂ der zweiten Schalterstufe 2 hat dies keine praktische Bedeutung. Eine Temperaturabhängigkeit der Schwellspannung Uᵢₙ₁ der ersten Schalterstufe 1 ist jedoch störend. Sie läßt sich allerdings ohne Schwierigkeiten dadurch unterdrücken, daß die negativen Temperaturkoeffizienten der Basis-Emitter-Spannungen der Transistoren T1 und T3 durch Verwendung von integrierten Widerständen R2, R3 mit unterschiedlichen Temperaturkoeffizienten ausgeglichen werden, wobei für die Temperaturkoeffizienten TK gilt: TK(R2) > TK(R3).

Damit wird eine von der Eingangsschaltung völlig unbeeinflußte Ansteuerung der Endstufe für Eingangsspannungen oberhalb der Schwellspannung Uᵢₙ₁ der ersten Schalterstufe 1 und ein weitgehender Schutz gegen elektrische und elektromagnetische Störeinflüsse sichergestellt.

## Patentansprüche

1. Eingangsschaltung für eine Endstufe (6) zur Unterdrückung von elektrischen und elektromagnetischen Störeinflüssen in Ansteuersignalen, mit
a) einem Signaleingang (I), wobei der Signaleingang (I) mit einer die Ansteuersignale tragenden Signalleitung (3) verbunden ist,
b) einem Signalausgang (O), wobei der Signalausgang (O) mit der zu steuernden Endstufe (6) verbunden ist,
c) einem Masseanschluss,
d) einer ersten Schalterstufe (1) mit einem Steueranschluss (4), einem Signalanschluss und einem Ausgabeanschluss, wobei der Steueranschluss (4) mit einem Spannungsteiler (R2, R3) zwischen dem Potential am Signaleingang (I) und dem Masseanschluss und der Signalanschluss mit der Signalleitung (3) verbunden ist,
e) einer zweiten Schalterstufe (2) mit einem Steueranschluss (5), einem Signalanschluss und einem Ausgabeanschluss, wobei der Steueranschluss (5) mit dem Ausgabeanschluss der ersten Schalterstufe (1), der Signalanschluss mit der Signalleitung (3) und der Ausgabeanschluss mit dem Signalausgang (O) verbunden ist, wobei
f) die erste Schalterstufe (1) bei Überschreitung eines ersten Schwellwerts (Uᵢₙ₁) und die zweite Schalterstufe (2) bei Überschreitung eines zweiten Schwellwerts (Uᵢₙ₂) von einem ersten Zustand, in dem das Potential am jeweiligen Ausgabeanschluss dem Potential am Signaleingang (I) folgt, in einen zweiten Zustand umschaltet, in dem das Potential am jeweiligen Ausgabeanschluss auf Masse gezogen ist, wobei der erste Schwellwert (Uᵢₙ₁) höher ist als der zweite Schwellwert (Uᵢₙ₂), wobei
g) die erste Schalterstufe (1) einen ersten Widerstand (R5) und einen ersten Transistor (T1) und die zweite Schalterstufe (2) einen zweiten Widerstand (R6) und einen zweiten Transistor (T2) umfasst, wobei jeweils der Widerstand zwischen den Kollektor des jeweiligen Transistors und den jeweiligen Signalanschluss geschaltet ist und der Emitter des jeweiligen Transistors mit der Masse verbunden ist, wobei
h) die zweite Schalterstufe (2) einen vierten Transistor (T4) umfasst , dessen Kollektor mit dem Signalanschluss der zweiten Schalterstufe verbunden ist, dessen Basis vom Kollektor des zweiten Transistors (T2) gesteuert wird und dessen Emitter den Ausgabeanschluss der zweiten Schalterstufe bildet..

2. Eingangsschaltung nach Anspruch 1, **dadurch gekennzeichnet, dass** die erste Schalterstufe (1) einen dritten Transistor (T3) umfasst, dessen Basis den Steueranschluss (4) der Schalterstufe bildet und dessen Emitter die Basis des ersten Transistors (T1) steuert.

3. Eingangsschaltung einem der vorhergehenden Ansprüche mit einem zwischen die Basis des vierten Transistors (T4) und Masse geschaltetem Widerstand (R9).

4. Eingangsschaltung nach einem der vorhergehenden Ansprüche, wobei der Spannungsteiler Widerstände (R2; R3) mit unterschiedlichen Temperaturkoeffizienten aufweist.

5. Eingangsschaltung nach einem der vorhergehenden Ansprüche, bei der die zweite Schwellspannung (Uᵢₙ₁) im Bereich der Haltleitergrenzschichtübergangsspannung liegt und die. erste Schwellspannung (Uᵢₙ₂) größer als 2 Volt ist.

6. Eingangsschaltung nach einem der vorhergehenden Ansprüche, die monolithisch integriert ist.

## Claims

1. Input circuit for an output stage (6) for suppressing electrical and electromagnetic interference influences in drive signals, having
a) a signal input (I), with the signal input (I) being connected to a signal line (3) which carries the drive signals,
b) a signal output (O), with the signal output (O) being connected to the output stage (6) to be controlled,
c) an earth connection,
d) a first switch stage (1) having a control connection (4), a signal connection and an output connection, with the control connection (4) being connected to a voltage divider (R2, R3) between the potential at the signal input (I) and the earth connection and the signal connection being connected to the signal line (3),
e) a second switch stage (2) with a control connection (5) a signal connection and an output connection, with the control connection (5) being connected to the output connection of the first switch stage (1), the signal connection being connected to the signal line (3), and the output connection being connected to the signal output (O), with
f) the first switch stage (1) switching from a first state, in which the potential at the respective output connection follows the potential at the signal input (I), to a second state, in which the potential at the respective output connection is drawn to earth, when a first threshold value (Uᵢₙ₁) is exceeded, and the second switch stage (2) switching from the first state to the second state when a second threshold value (Uᵢₙ₂) is exceeded, with the first threshold value (Uᵢₙ₁) being higher than the second threshold value (Uᵢₙ₂), with
g) the first switch stage (1) having a first resistor (R5) and a first transistor (T1), and the second switch stage (2) having a second resistor (R6) and a second transistor (T2), with the resistor in each case being connected between the collector of the respective transistor and the respective signal connection, and the emitter of the respective transistor being connected to earth, with
h) the second switch stage (2) having a fourth transistor (T4), whose collector is connected to the signal connection of the second switch stage, whose base is controlled by the collector of the second transistor (T2), and whose emitter forms the output connection of the second switch stage.

2. Input circuit according to Claim 1, **characterized in that** the first switch stage (1) has a third transistor (T3), whose base forms the control connection (4) of the switch stage and whose emitter controls the base of the first transistor (T1).

3. Input circuit according to one of the preceding claims, having a resistor (R9) which is connected between the base of the fourth transistor (T4) and earth.

4. Input circuit according to one of the preceding claims, with the voltage divider having resistors (R2; R3) with different temperature coefficients.

5. Input circuit according to one of the preceding claims, in which the second threshold voltage (Uᵢₙ₁) is in the region of the semiconductor junction voltage, and the first threshold voltage (Uᵢₙ₂) is greater than 2 volts.

6. Input circuit according to one of the preceding claims, which is monolithically integrated.

## Revendications

1. Circuit d'entrée pour un étage final (6) destiné à empêcher des influences perturbatrices électriques et électromagnétiques dans des signaux d'excitation, avec
a) une entrée de signal (I), l'entrée de signal (I) étant reliée à un câble de signal (3) qui transmet les signaux d'excitation,
b) une sortie de signal (O), la sortie de signal (O) étant reliée à l'étage final (6) à commander,
c) un raccord à la masse,
d) un premier étage de commutateur (1) avec un raccordement de commande (4), avec un raccordement de signal et avec un raccordement de sortie, le raccordement de commande (4) étant relié à un diviseur de tension (R2, R3) entre le potentiel sur l'entrée de signal (I) et le raccord à la masse et le raccordement de signal étant relié au câble de signal (3),
e) un deuxième étage de commutateur (2) avec un raccordement de commande (5), avec un raccordement de signal et avec un raccordement de sortie, le raccordement de commande (5) étant relié au raccordement de sortie du premier étage de commutateur (1), le raccordement de signal au câble de signal (3) et le raccordement de sortie à la sortie du signal (O), pour lequel
f) le premier étage de commutateur (1) en cas de dépassement d'une première valeur seuil (Uᵢₙ₁) et le deuxième étage de commutateur (2) en cas de dépassement d'une deuxième valeur seuil (Uᵢₙ₂) passe d'un premier état, où le potentiel sur le raccordement de sortie concerné suit le potentiel à l'entrée de signal (I), à un deuxième état où le potentiel au raccordement de sortie concerné est amené à la masse, la première valeur seuil (Uᵢₙ₁) étant supérieure à la deuxième valeur seuil (Uᵢₙ₂), pour lequel
g) le premier étage de commutateur (1) comprend une première résistance (R5) et un premier transistor (T1) et le deuxième étage de commutateur (2) une deuxième résistance (R6) et un deuxième transistor (T2), à chaque fois la résistance étant montée entre le collecteur du transistor concerné et le raccordement de signal concerné, et l'émetteur du transistor concerné étant relié à la masse, alors que
h) le deuxième étage de commutateur (2) comprend un quatrième transistor (T4) dont le collecteur est relié au raccordement de signal du deuxième étage de commutateur dont la base est commandée par le collecteur du deuxième transistor (T2) et dont l'émetteur forme le raccordement de sortie du deuxième étage de commutateur.

2. Circuit d'entrée selon la revendication 1,
**caractérisé en ce que**
le premier étage de commutateur (1) comprend un troisième transistor (T3) dont la base forme le raccordement de commande (4) de l'étage de commutateur et dont l'émetteur commande la base du premier transistor (T1).

3. Circuit d'entrée selon l'une des revendications précédentes,
**caractérisé par**
une résistance (R9) montée entre la base du quatrième transistor (T4) et la masse.

4. Circuit d'entrée selon l'une des revendications précédentes,
**caractérisé en ce que**
le diviseur de tension présente des résistances (R2 ; R3) avec des coefficients de température différents.

5. Circuit d'entrée selon l'une des revendications précédentes,
**caractérisé en ce que**
la deuxième valeur seuil (Uᵢₙ₁) se situe dans la plage de tension transitoire de la couche limite du câble de maintien et la première valeur seuil (Uᵢₙ₂) est supérieure à 2 volts.

6. Circuit d'entrée selon l'une des revendications précédentes,
**caractérisé en ce que**
il est intégré de façon monolithique.
